# FASCICULE DE BREVET EUROPEEN

(11) **EP 3 036 776 B1**
(45) Date de publication et mention de la délivrance du brevet: **17.10.2018**
(21) Numéro de dépôt: 14755068.5
(22) Date de dépôt: 21.08.2014
(51) Int. Cl.: H01L 33/06, H01L 33/32, H01L 33/08, H01L 33/18, H01L 33/00

(54) **DIODE ÉLLECTROLUMINESCENTE DONT UNE ZONE ACTIVE COMPORTÉ DES COUCHES D'INN**
LEUCHTDIODE MIT EINER AKTIVEN REGION, DIE INN SCHICHTEN UMFASST
LIGHT EMITTING DIODE WITH AN ACTIVE REGION COMPRISING INN LAYERS

(30) Priorité: 22.08.2013 FR 1358121
(43) Date de publication de la demande: 29.06.2016
(73) Titulaire: Commissariat à l'Énergie Atomique et aux Énergies Alternatives, 75015 Paris (FR); Aledia, 38040 Grenoble (FR)
(72) Inventeur: ROBIN, Ivan-Christophe, F-38000 Grenoble (FR); DUSSAIGNE, Amélie, 38260 Saint Hilaire de la Côte (FR)
(74) Mandataire: Brevalex
(86) Numéro de dépôt international: PCT/EP2014/067843
(87) Numéro de publication internationale: WO 2015/025007

(56) Documents cités:
- EP-A1- 1 903 619
- EP-A2- 1 411 559
- AKIHIKO YUKI ET AL: "1-2 ML thick InN-based quantum wells with InGaN barriers for blue-green light emitters", PHYSICA STATUS SOLIDI (C), vol. 6, no. S2, 26 juin 2009 (2009-06-26), pages S417-S420, XP055113385, ISSN: 1862-6351, DOI: 10.1002/pssc.200880969 cité dans la demande

## Description

### DOMAINE TECHNIQUE ET ART ANTÉRIEUR

L'invention concerne le domaine des diodes électroluminescentes (appelées DELs ou LEDs), ainsi que celui des dispositifs émissifs lumineux à base de telles LEDs (écrans, projecteurs, murs d'images, etc.). L'invention s'applique avantageusement à des LEDs émettant dans la gamme des longueurs d'ondes correspondant à la couleur verte et/ou rouge, c'est-à-dire dans la gamme des longueurs d'ondes comprises entre environ 500 nm et 700 nm.

Actuellement, les LEDs émettant dans la gamme des longueurs d'ondes correspondant à la couleur verte sont principalement fabriquées avec des puits quantiques d'InGaN comprenant une importante composition en indium, c'est-à-dire supérieure à environ 25%, par rapport au gallium. De telles LEDs sont par exemple décrites dans les documents US 2013/0028281 A1 et « Approaches for high internai quantum efficiency green InGaN light-emitting diodes with large overlap quantum wells » de H. Zhao et al., Optics Express, Vol. 19, Issue S4, pp. A991-A1007, 2011. Un des problèmes de ces LEDs est qu'une démixtion d'alliage se produit dans de tels puits quantiques d'InGaN, ce qui ne permet pas d'obtenir de bonnes efficacités radiatives au sein de tels puits quantiques en raison des défauts engendrés par cette démixtion d'alliage. Un autre problème de ces LEDs est lié à la forte contrainte qui existe entre le GaN des couches barrières (entre lesquelles se trouvent les puits quantiques) et l'InGaN des puits quantiques, cette contrainte résultant de la différence de rapports de maille entre ces deux matériaux et entrainant la formation de défauts, par exemple des dislocations, dans les puits quantiques. Cette contrainte a aussi tendance à favoriser la démixtion de l'InGaN des puits quantiques.

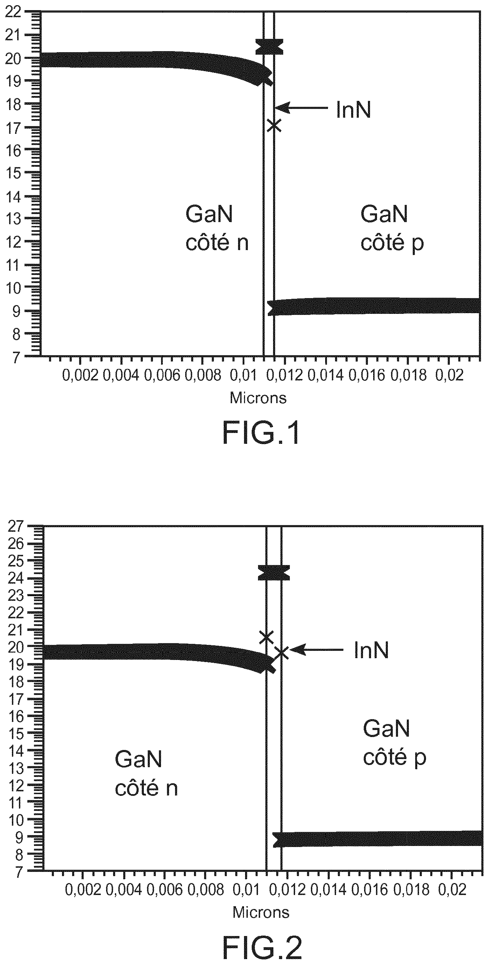

Pour réduire les dislocations dans les puits quantiques, le document « Proposai and achievement of novel structure InN/GaN multiple quantum wells consisting of 1 ML and fractional monolayer InN wells inserted in GaN matrix » de A. Yoshikawa et al., Appl. Phys. Lett. 90, 073101 (2007) décrit une LED à multiples puits quantiques chacun formé par une couche d'InN dont l'épaisseur est égale à une ou deux monocouches, chaque couche d'InN étant disposée entre deux couches barrières de GaN d'épaisseur égale à environ 15 nm. La figure 1 représente le taux de recombinaisons radiatives, en échelle logarithmique et par cm³.s, obtenu dans une LED comprenant un puits quantique formé d'une couche d'InN d'épaisseur égale à 2 monocouches et disposée entre deux couches barrières de GaN chacune d'épaisseur égale à environ 10 nm. Or, on voit sur cette figure que le taux de recombinaisons radiatives dans la couche d'InN est du même ordre de grandeur que celui dans la couche barrière de GaN se trouvant du côté n de la LED, et est relativement faible (de l'ordre de 10²¹ recombinaisons.cm⁻³.s⁻¹) en raison de la très faible densité d'états dans la couche d'InN. De plus, avec un tel puits quantique, il est difficile de réaliser une émission lumineuse dans la gamme des longueurs d'ondes correspondant à la couleur verte.

Pour répondre au problème de gamme de longueurs d'ondes d'émission de la LED décrite ci-dessus, le document « 1-2 ML thick InN-based quantum wells with InGaN barriers for blue-green light emitters » de A. Yuki et al., PHYSICA STATUS SOLIDI C 6; n°S2; S417-S420 (2009) propose de séparer les différents puits quantiques non pas par des couches barrières de GaN, mais par des couches barrières d'InGaN chacune d'épaisseur égale à environ 10 nm. L'utilisation d'InGaN pour réaliser les couches barrières entre les différents puits quantiques permet d'augmenter les valeurs des longueurs d'ondes émises par la LED.

La figure 2 représente le taux de recombinaisons radiatives, en échelle logarithmique et par cm³.s, obtenu dans un puits quantique formé d'une couche d'InN d'épaisseur égale à 2 monocouches et disposée entre deux couches barrières d'In_{0,2}Ga_{0,8}N chacune d'épaisseur égale à environ 10 nm. Or, comme pour le puits quantique dont le taux de recombinaisons radiatives est représenté sur la figure 1, le taux de recombinaisons radiatives dans la couche d'InN est ici également du même ordre de grandeur que celui dans la couche barrière d'InGaN se trouvant du côté n de la LED, et est relativement faible (de l'ordre de 10²¹ recombinaisons.cm⁻³.s⁻¹) en raison de la très faible densité d'états dans la couche d'InN.

Le document US 2011/0204328 A1 décrit un puits quantique symétrique comprenant une couche centrale d'InN disposée entre deux couches barrières d'InGaN. Comme précédemment, la très faible densité d'états dans la couche d'InN ne permet pas d'avoir un taux de recombinaisons radiatives satisfaisant pour obtenir une émission suffisante dans la gamme des longueurs d'ondes souhaitées.

Le document EP 1 903 619 A1 enseigne que l'utilisation d'une suite de puits quantiques séparés par une barrière mince dont le premier puits sur le chemin des électrons a une énergie de transition supérieure à celle du deuxième puits, permet un meilleur raccordement des concentrations de trous et d'électrons dans la zone active.

### EXPOSÉ DE L'INVENTION

Un but de la présente invention est de proposer une diode électroluminescente permettant d'obtenir un meilleur taux de recombinaisons radiatives et avoir ainsi une meilleurs efficacité d'émission, notamment dans la gamme des longueurs d'ondes correspondant à la couleur verte ou rouge, tout en évitant les problèmes de défauts et de démixtion d'alliage dans la zone active de la diode électroluminescente.

Pour cela, la présente invention propose un diode électroluminescente comportant au moins une couche d'In_{Xn}Ga_{(1-Xn)}N dopé n et une couche d'In_{Xp}Ga_{(1-Xp)}N dopé p formant ensemble une jonction p-n de la diode , et une zone active disposée entre la couche d'In_{Xn}Ga_{(1-Xn)}N dopé n et la couche d'In_{Xp}Ga_{(1-Xp)}N dopé p et dans laquelle des recombinaisons radiatives sont aptes à se produire, la zone active comprenant au moins :
- une première couche d'InN d'épaisseur e_{InN106} ;
- une deuxième couche d'InN d'épaisseur e_{InN108} ;
- une couche de séparation disposée entre la première couche d'InN et la deuxième couche d'InN et telle que la première couche d'InN soit disposée entre la couche de séparation et la couche d'In_{Xn}Ga_{(1-Xn)}N dopé n, la couche de séparation comprenant de l'In_{Xb}Ga_{(1-Xb)}N et une épaisseur inférieure ou égale à environ 3 nm ;
- une couche d'In_{X1}Ga_{(1-X1)}N disposée entre la couche d'In_{Xn}Ga_{(1-Xn)}N dopé n et la première couche d'InN ;
- une couche d'In_{X2}Ga_{(1-X2)}N disposée entre la couche d'In_{Xp}Ga_{(1-Xp)}N dopé p et la deuxième couche d'InN ;
dans laquelle les compositions en indium Xn, Xp, Xb, X1 et X2 sont comprises entre 0 et environ 0,25, et dans laquelle les épaisseurs e_{InN106} et e_{InN108} sont telles que e_{InN106} ≤ e_{InN108}.

Grâce à la faible épaisseur de la couche séparant les deux couches d'InN, les porteurs de charge peuvent facilement passer d'une couche d'InN à l'autre. Ainsi, la deuxième couche d'InN se trouvant du côté p de la diode forme un réservoir de trous, ces trous passant facilement dans la première couche d'InN qui se trouve du côté n de la diode. Des concentrations sensiblement équivalentes en électrons et en trous sont obtenues dans la première couche d'InN, ce qui permet d'avoir un très fort taux de recombinaisons radiatives dans cette première couche d'InN, et donc une meilleure efficacité d'émission de la diode électroluminescente que celles de l'art antérieur. De plus, compte tenu des matériaux utilisés, une émission lumineuse dans la gamme des longueurs d'ondes correspondant à la couleur verte ou rouge est bien obtenue. Enfin, cette excellente efficacité d'émission est obtenue sans faire appel à de l'InGaN à forte concentration d'indium, ce qui permet d'éviter les problèmes de démixtion d'alliage et de défauts dans la zone active de la diode électroluminescente.

L'épaisseur inférieure ou égale à 3 nm de la couche séparant les deux couches d'InN permet donc d'obtenir un effet tunnel asymétrique, c'est-à-dire que les électrons sont piégés dans la première couche d'InN (celle se trouvant du côté de la couche d'In_{Xn}Ga_{(1-Xn)}N dopé n) alors que les trous peuvent passer de la deuxième couche d'InN (celle se trouvant du côté de la couche d'In_{Xp}Ga_{(1-Xp)}N dopé p) à la première couche d'InN. La deuxième couche d'InN forme un réservoir de trous et la première couche d'InN forme la couche émissive de la diode.

Les épaisseurs e_{InN106} et e_{InN108} peuvent être comprises entre 1 monocouche et 3 monocouches, et avantageusement entre 1 monocouche et 2 monocouches.

Lorsque l'une ou chacune de la première couche d'InN et de la deuxième couche d'InN a une épaisseur comprise entre 2 monocouches et 3 monocouches, la composition en indium Xb peut être supérieure ou égale à environ 0,15. Lorsque la composition en indium Xb est inférieure à environ 0,15, l'épaisseur de ladite une ou de chacune de la première couche d'InN et de la deuxième couche d'InN peut être inférieure ou égale à 2 monocouches.

Les épaisseurs e_{InN106} et e_{InN108} peuvent être telles que e_{InN106} < e_{InN108}. Cette configuration permet d'accentuer les rôles de couche émissive et de réservoir de trous remplis respectivement par la première couche d'InN et par la deuxième couche d'InN.

Les compositions en indium X1 et X2 peuvent être telles que X1 ≤ X2. Les compositions en indium Xn, Xp, X1 et X2 peuvent être telles que Xn < X1 < X2 < Xp, ce qui permet d'homogénéiser la répartition des électrons dans les différentes couches de la zone active. Les compositions en indium Xn, Xp, X1, Xb et X2 peuvent être telles que Xn = Xp = 0 et/ou X1 = Xb = X2, ce qui permet de simplifier la réalisation de la diode électroluminescente.

L'épaisseur de la couche d'In_{Xn}Ga_{(1-Xn)}N dopé n et/ou l'épaisseur de la couche l'In_{Xp}Ga_{(1-Xp)}N dopé p peut être comprise entre environ 20 nm et 10 µm, et/ou l'épaisseur de la couche d'In_{X1}Ga_{(1-X1)}N et/ou l'épaisseur de la couche d'In_{X2}Ga_{(1-X2)}N peut être comprise entre environ 1 nm et 200 nm.

La diode électroluminescente peut comporter en outre une première électrode métallique disposée contre la couche d'In_{Xn}Ga_{(1-Xn)}N dopé n et une deuxième électrode métallique disposée contre la couche l'In_{Xp}Ga_{(1-Xp)}N dopé p.

La zone active de la diode électroluminescente peut comporter un nombre de couches d'InN supérieur à 2, chacune des couches d'InN étant séparée de la ou de chacune des couches d'InN adjacentes par une couche de séparation comprenant de l'InGaN ou du GaN et d'épaisseur inférieure ou égale à environ 3 nm.

La diode électroluminescente peut comporter plusieurs zones actives disposées entre la couche d'In_{Xn}Ga_{(1-Xn)}N dopé n et la couche d'In_{Xp}Ga_{(1-Xp)}N dopé p et dans lesquelles des recombinaisons radiatives sont aptes à se produire.

La diode électroluminescente peut comporter en outre, entre la couche d'In_{Xn}Ga_{(1-Xn)}N dopé n et la zone active, une couche tampon d'InGaN dopé n, l'InGaN dopé n de la couche tampon comportant une énergie de bande interdite inférieure ou égale à environ 97 % de l'énergie de bande interdite de l'In_{Xp}Ga_{(1-Xp)}N dopé p.

L'invention concerne également un procédé de réalisation d'une diode électroluminescente telle que décrite ci-dessus, dans lequel les couches de la diode électroluminescente sont des couches planaires réalisées par croissance les unes au-dessus des autres, ou dans lequel les couches de la diode électroluminescente sont réalisées par croissance sous la forme de nanofils radiaux ou axiaux.

L'invention concerne également un dispositif émissif lumineux comprenant au moins une diode électroluminescente telle que décrite ci-dessus.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent des taux de recombinaisons radiatives obtenus dans des diodes électroluminescentes de l'art antérieur;
- la figure 3 représente schématiquement une diode électroluminescente, objet de la présente invention, selon un mode de réalisation particulier ;
- la figure 4 représente le taux de recombinaisons radiatives obtenu dans la zone active d'une diode électroluminescente, objet de la présente invention, selon un premier exemple de réalisation ;
- la figure 5 représente les concentrations en électrons et en trous obtenues dans la zone active de la diode électroluminescente, objet de la présente invention, selon le premier exemple de réalisation ;
- la figure 6 représente le taux de recombinaison radiatives obtenu dans une diode électroluminescente, objet de la présente invention, selon un deuxième exemple de réalisation ;
- les figures 7A et 7B représentent schématiquement des diodes électroluminescentes, objets de la présente invention, réalisées sous la forme de nanofils.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

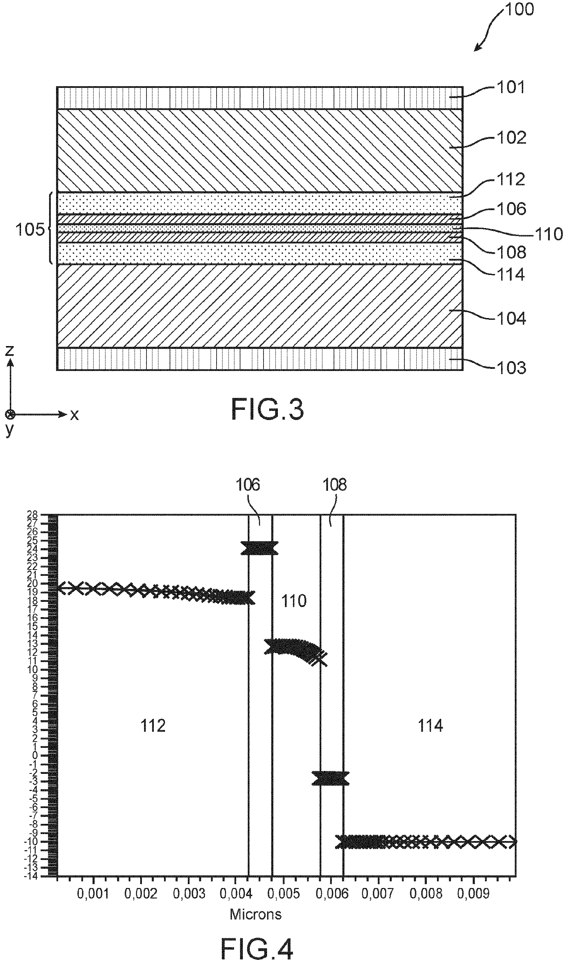

On se réfère tout d'abord à la figure 3 qui représente schématiquement une diode électroluminescente 100, ou LED 100, selon un mode de réalisation particulier. Dans la notation In_{X}Ga_{(1-X)}N utilisée par la suite, X représente la composition en indium du matériau, c'est-à-dire la proportion d'indium par rapport à la quantité totale d'indium et de gallium dans le matériau In_{X}Ga_{(1-X)}N.

La LED 100 comporte une jonction p-n formée par une couche d'In_{Xn}Ga_{(1-Xn)}N dopé n 102 (également appelé In_{Xn}Ga_{(1-Xn)}N-n), avec une concentration de donneurs égale à environ 3.10¹⁸ donneurs/cm³, et une couche d'In_{Xp}Ga_{(1-Xp)}N dopé p 104 (également appelé In_{Xp}Ga_{(1-Xp)}N-p) avec une concentration d'accepteurs égale à environ 2.10¹⁹ accepteurs/cm³. Ces deux couches dopées 102 et 104 ont par exemple chacune une épaisseur (dimension selon l'axe Z représenté sur la figure 3) comprise entre environ 20 nm et 10 µm. Une première électrode métallique 101 est disposée contre la couche d'In_{Xn}Ga_{(1-Xn)}N-n 102 et forme une cathode de la LED 100, et une deuxième électrode métallique 103 est disposée contre la couche d'In_{Xp}Ga_{(1-Xp)}N-p 104 et forme une anode de la LED 100. De manière générale, la couche d'In_{Xn}Ga_{(1-Xn)}N-n 102 peut avoir une concentration de donneurs comprise entre environ 10¹⁷ et 10²⁰ donneurs/cm³, et la couche d'In_{Xp}Ga_{(1-Xp)}N-p 104 peut avoir une concentration d'accepteurs comprise entre environ 10¹⁵ et 10²⁰ accepteurs/cm³.

La LED 100 comporte, entre les couches dopées 102 et 104, une zone active 105 dans laquelle se produisent des recombinaisons radiatives entrainant une émission lumineuse de la LED 100. La zone active 105 comporte notamment une première couche d'InN 106 se trouvant du côté de la couche d'In_{Xn}Ga_{(1-Xn)}N-n 102, et une deuxième couche d'InN 108 se trouvant du côté de la couche d'In_{Xp}Ga_{(1-Xp)}N-p 104. Les deux couches d'InN 106 et 108 sont séparées l'une de l'autre par une fine couche de séparation 110 comprenant de l'In_{Xb}Ga_{(1-Xb)}N. De plus, la première couche d'InN 106 est séparée de la couche d'In_{Xn}Ga_{(1-Xn)}N-n 102 par une couche d'In_{X1}Ga_{(1-X1)}N 112, et la deuxième couche d'InN 108 est séparée de la couche d'In_{Xp}Ga_{(1-Xp)}N-p 104 par une couche d'In_{X2}Ga_{(1-X2)}N 114.

Toutes les couches de la zone active 105 de la LED 100 (c'est-à-dire les couches 106, 108, 110, 112 et 114 sur l'exemple de la figure 3) comportent de matériaux non intentionnellement dopés (de concentration en donneurs résiduels n_{nid} égale à environ 10¹⁷ cm⁻³, ou comprise entre environ 10¹⁶ et 10²⁰ donneurs/cm³).

De manière générale, chacune des compositions en indium X1, X2 et Xb peut être comprise entre 0 et 0,25 (lorsque l'une de ces compositions en indium a une valeur nulle, le matériau associé à cette composition est alors du GaN). De plus, on a également X1 ≤ X2. De manière avantageuse, les compositions en indium X1 et X2 sont telles que 0,05 ≤ X1 ≤ 0,08 et 0,12 ≤ X2 ≤ 0,2, et la composition en indium Xb est telle que 0,05 ≤ Xb ≤ 0,2.

Les compositions en indium Xn, X1, X2 et Xp respectivement des couches 102, 112, 114 et 104 sont avantageusement telles que Xn < X1 < X2 < Xp, ce qui permet d'homogénéiser la répartition des électrons dans les couches de la zone active 105 de la LED 100. Ces compositions en indium sont par exemple telles que Xn = 0 (ce qui signifie dans ce cas que la couche dopée n 102 comporte du GaN-n), X1 = 0,05, X2 = 0,1 et Xp = 0,18.

Afin de simplifier la réalisation de la LED 100, il est possible d'avoir Xn = Xp = 0 (les couches dopées 102 et 104 comportant alors respectivement du GaN-n et du GaN-p) et/ou d'avoir X1 = Xb = X2, ce qui permet par exemple de réaliser les couches 102, 104, 110, 112 et 114 avec une même température de croissance et/ou de réaliser les couches 106 et 108 avec une même température de croissance.

Les épaisseurs (dimensions selon l'axe Z représenté sur la figure 3) des couches d'InN 106 et 108, appelées respectivement e_{InN106} et e_{InN108}, sont telles que e_{InN106} ≤ e_{InN108}. Chacune de ces épaisseurs e_{InN106} et e_{InN108} est comprise entre 1 monocouche et 3 monocouches (1 monocouche d'InN correspondant à une épaisseur égale à environ 0,25 nm), et de préférence entre 1 monocouche et 2 monocouches. Toutefois, lorsque l'une ou chacune des deux épaisseurs e_{InN106} et e_{InN108} est comprise entre 2 monocouches et 3 monocouches, il est par exemple possible d'avoir Xb ≥ 0,15. De manière complémentaire, lorsque Xb < 0,15, l'épaisseur de cette ou de chacune de ces couches est de préférence choisie inférieure ou égale à environ 2 monocouches.

Afin de permettre aux porteurs de charges de passer facilement de la deuxième couche d'InN 108 à la première couche d'InN 106, l'épaisseur de la couche de séparation 110 est inférieure ou égale à environ 3 nm, et avantageusement inférieure ou égale à environ 2 nm. Contrairement à deux puits quantiques réalisés l'un à côté de l'autre, les deux couches d'InN 106 et 108 font parties de la même zone active de la LED 100 et fonctionnent conjointement pour réaliser une émission lumineuse depuis cette zone active 105 de la LED 100. Les épaisseurs des couches 112 et 114 sont comprises entre environ 1 nm et 200 nm.

On décrit ci-dessous un premier exemple de réalisation de la diode 100.

La couche dopée n 102 a une épaisseur égale à environ 500 nm et comporte du GaN-n avec une concentration de donneurs égale à environ 3.10¹⁸ donneurs/cm³. La couche dopée p 104 a une épaisseur égale à environ 500 nm et comporte du GaN-p avec une concentration d'accepteurs égale à environ 2.10¹⁹ accepteurs/cm³. Les couches 112 et 114 ont chacune une épaisseur égale à environ 5 nm et comportent du GaN non intentionnellement dopé (GaN-nid) de concentration en donneurs résiduels n_{nid} égale à environ 10¹⁷ cm⁻³. Les couches d'InN 106 et 108 ont chacune une épaisseur égale à environ 2 monocouches et comportent de l'InN-nid. Enfin, la couche de séparation 110 a une épaisseur égale à environ 1 nm et comporte de l'In_{0,2}Ga_{0,8}N-nid.

Les simulations décrites ci-dessous sont réalisées avec le logiciel de simulation SILVACO® d'ATLAS®.

La figure 4 représente le taux de recombinaisons radiatives obtenues dans les différentes couches de la zone active 105 de la LED 100 selon le premier exemple de réalisation décrit ci-dessus. Les références des différentes couches de la LED 100 sont rappelées sur la figure 4, les traits verticaux représentés sur la figure 4 symbolisant les interfaces entres les couches de la LED 100. On voit sur cette figure qu'un taux maximum de recombinaisons radiatives d'environ 10²⁴ recombinaisons.cm⁻³.s⁻¹ est obtenu dans la première couche d'InN 106 se trouvant du côté de la couche de GaN-n 102, ce qui est bien supérieur au taux d'environ 10²¹ recombinaisons.cm⁻³.s⁻¹ obtenu avec un puits quantique formé d'une seule couche d'InN disposée entre deux couches barrières d'InGaN ou de GaN comme précédemment décrit en liaison avec les figures 1 et 2.

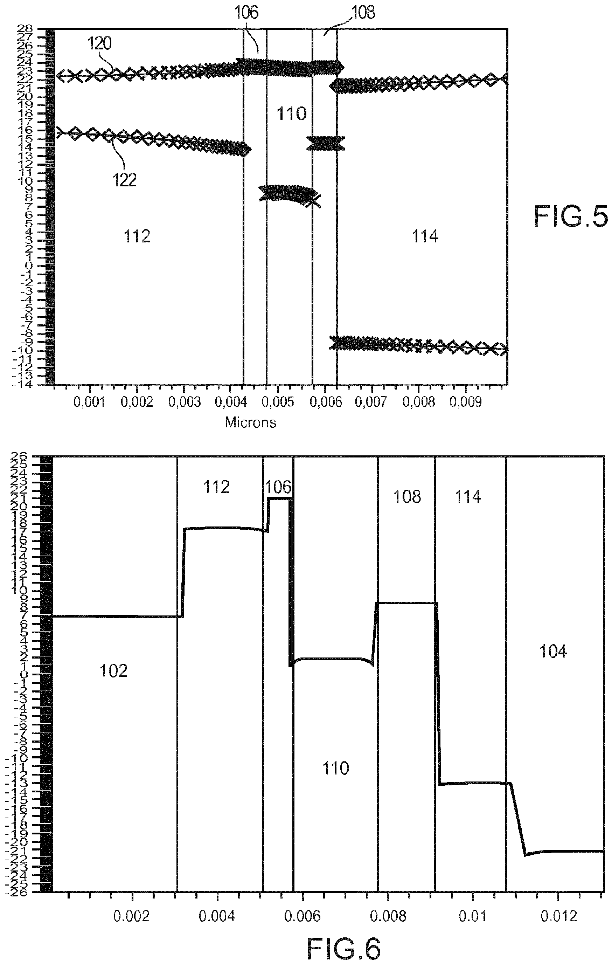

La figure 5 représente les concentrations en électrons (représentées par des croix référencées 120) et en trous (représentées par des losanges référencés 122), par cm³, obtenues dans les différentes couches de la zone active 105 de la LED 100 selon le premier exemple de réalisation décrit ci-dessus. Cette figure montre bien que dans la première couche d'InN 106, du côté de la couche dopée n 102, les concentrations en électrons et en trous sont sensiblement équivalentes, ce qui permet d'avoir un fort taux de recombinaisons radiatives dans cette première couche d'InN 106. Cette bonne efficacité radiative dans la première couche d'InN 106 se trouvant du côté de la couche dopée n 102, est obtenue notamment grâce à l'utilisation de la fine couche de séparation 110 entre les deux couches d'InN 106, 108 car la deuxième couche d'InN 108 forme alors, vis-à-vis de la première couche d'InN 106, un réservoir de trous à partir de laquelle ces trous migrent dans la première couche d'InN 106.

On décrit ci-dessous un deuxième exemple de réalisation de la LED 100.

La couche dopée n 102 a une épaisseur égale à environ 500 nm et comporte du GaN-n avec une concentration de donneurs égale à environ 3.10¹⁸ donneurs/cm³. La couche dopée p 104 a une épaisseur égale à environ 500 nm et comporte du GaN-p avec une concentration d'accepteurs égale à environ 2.10¹⁹ accepteurs/cm³. Les couches 112 et 114 ont chacune une épaisseur égale à environ 2 nm et comportent de l'In_{0,2}Ga_{0,8}N non intentionnellement dopé (In_{0,2}Ga_{0,8}N-nid) de concentration en donneurs résiduels n_{nid} égale à environ 10¹⁷ cm⁻³. Les deux couches d'InN 106 et 108 comportent toutes les deux de l'InN-nid. Dans ce deuxième exemple de réalisation, les deux couches d'InN 106 et 108 ont par contre des épaisseurs différentes. Ainsi, la première couche d'InN 106 se trouvant du côté de la couche dopée n 102 a une épaisseur égale à environ 1 monocouche et la deuxième couche d'InN 108 se trouvant du côté de la couche dopée p 104 a une épaisseur égale à environ 3 monocouches. Enfin, la couche de séparation 110 a une épaisseur égale à environ 2 nm et comporte de l'In_{0,2}Ga_{0,8}N-nid. Le taux de recombinaisons radiatives obtenu dans la LED 100 selon ce deuxième exemple de réalisation est représenté sur la figure 6.

Cette dissymétrie entre les épaisseurs des couches d'InN 106 et 108 permet de favoriser l'émission lumineuse réalisée par la couche d'InN la plus fine (ici la première couche d'InN 106 se trouvant du côté de la couche dopée n 102) car cette faible épaisseur permet d'avoir un meilleur contrôle de l'émission lumineuse réalisée par la première couche d'InN 106. D'une part, l'épaisseur plus importante de la deuxième couche d'InN 108 permet d'accentuer le rôle de réservoir, ou de capture, de trous rempli par cette couche, et donc d'augmenter le taux de recombinaisons se produisant dans la première couche d'InN 106. D'autre part, avec une telle structure, du fait que la première couche d'InN 106 est plus fine, ce qui entraîne une augmentation de l'énergie de transition dans la première couche d'InN 106 sans en modifier le gap, on obtient une émission lumineuse efficace pour des longueurs d'ondes égales à environ 530 nm, c'est-à-dire des longueurs d'ondes correspondant à la couleur verte.

Dans tous les modes et exemples de réalisation précédemment décrits, la zone active 105 de la LED 100 peut comporter plus de deux couches d'InN-nid, chacune de ces couches d'InN étant dans ce cas séparée de la ou de chacune des couches d'InN adjacentes par une fine couche de séparation similaire à la couche 110 et comprenant de l'InGaN (la proportion d'indium de l'InGaN de chacune de ces fines couches de séparation pouvant être similaire ou non d'une couche à l'autre) ou du GaN.

De plus, dans tous les modes et exemples de réalisation précédemment décrits, il est possible de réaliser la LED 100 telle qu'elle comporte, entre les couches dopées 102 et 104, plusieurs zones actives, par exemple similaires à la zone active 105 précédemment décrite, disposées les unes au-dessus des autres, et comportant chacune au moins deux couches d'InN séparées l'une de l'autre par une fine couche de séparation similaire à la couche de séparation 110 précédemment décrite. La LED forme alors une LED à multiples puits quantiques.

Selon une autre variante de réalisation de la LED 100, il est possible de former, entre la couche dopée n 102 et la couche 112 d'In_{X1}Ga_{(1-X1)}N, une couche tampon d'InGaN-n comportant une énergie de bande interdite inférieure ou égale à environ 97 % de l'énergie de bande interdite de l'In_{Xp}Ga_{(1-Xp)}N-p de la couche 104. Une telle couche tampon crée, de part son énergie de bande interdite inférieure ou égale à environ 97 % de l'énergie de bande interdite de la couche dopée p 104, c'est-à-dire telle que le gap de cette couche tampon soit inférieur d'au moins 3 % par rapport au gap de la couche dopée p 104 (Egₜₐₘₚₒₙ ≤ 0,97 Eg₁₀₄), une asymétrie dans la structure de la LED 100, et plus particulièrement une asymétrie dans la jonction p-n de la LED 100. Cette asymétrie facilite la circulation des trous dans la LED 100 et permet d'obtenir une répartition plus homogène des porteurs (électrons et trous) dans la zone active 105 de la LED 100. Cela se traduit par une meilleure émission lumineuse depuis la zone active 105 de la LED 100 et donc par un meilleur rendement quantique interne de la LED 100. Cette couche tampon comporte de l'InGaN avec avantageusement une composition en indium supérieure d'au moins 2,5 % par rapport à la valeur de Xp, c'est-à-dire de la composition en indium du semi-conducteur de la couche dopée p 104.

La couche tampon et la couche dopée n 102 peuvent comporter un semi-conducteur de composition et/ou de dopage identiques. Ainsi, la composition en indium du semi-conducteur de la couche dopée n 102 peut être similaire à la composition en indium du semi-conducteur de la couche tampon, et/ou la concentration de donneurs dans le semi-conducteur de la couche dopée n 102 peut être similaire à la concentration de donneurs dans le semi-conducteur dopé n de la couche tampon.

En variante, la composition en indium du semi-conducteur de la couche tampon peut varier le long de l'épaisseur de la couche tampon, formant ainsi un gradient dans la composition d'indium le long de l'épaisseur de la couche tampon. Il est également possible de réaliser un super-réseau (In,Ga)N/InGaN pour la couche tampon.

Il est également possible que la LED 100 comporte une couche de blocage d'électrons, par exemple à base d'AlGaN, disposée entre la couche 114 et la couche dopée p 104. Une telle couche de blocage d'électrons permet d'empêcher le passage des électrons vers la couche dopée p 104. Une telle couche de blocage d'électrons permet de diminuer également le DROOP, c'est-à-dire la chute de l'efficacité quantique interne lorsque la densité de courant dans la LED augmente, cette chute étant partiellement due à l'échappement des électrons de la zone active 105 quand le courant augmente.

Une telle LED 100 fonctionne quelle que soit l'orientation de la structure, que ce soit selon le plan c (sous la présence d'un fort champ électrique interne), le plan M, en semi-polaire, etc.

La LED 100 peut être réalisée sous la forme d'une diode planaire comme représenté sur la figure 3, c'est-à-dire sous la forme d'un empilement de couches formées sur un substrat (le substrat n'étant pas représenté sur la figure 3), les faces principales des différentes couches étant disposées parallèlement au plan du substrat (parallèles au plan (X,Y)).

On décrit ci-dessous un exemple de réalisation de la LED 100 sous la forme d'une telle diode planaire.

On réalise tout d'abord la croissance d'une première couche de GaN d'épaisseur égale à environ 2 µm sur un substrat saphir, par exemple par MOCVD (« MetalOrganic Chemical Vapour Déposition » en anglais) à une température d'environ 1000°C. Cette croissance est achevée en formant la couche 102 de GaN-n dopé par du silicium à 3.10¹⁸ donneurs/cm³, d'épaisseur égale à environ 500 nm. La température est ensuite abaissée à environ 830 °C pour faire croître environ 10 nm d'In_{0,05}Ga_{0,95}N non intentionnellement dopé, formant la couche 112. La température est ensuite abaissée à environ 600°C pour faire croître 3 monocouches d'InN non intentionnellement dopé, formant la première couche d'InN 106. La température est remontée à environ 720°C pour faire croître 1 nm d'In_{0,2}Ga_{0,8}N non intentionnellement dopé, formant la couche de séparation 110. La température est abaissée de nouveau à environ 600°C pour faire croître 2 monocouches d'InN non intentionnellement dopé, formant la deuxième couche d'InN 108. La température est remontée à environ 750°C pour faire croître 10 nm d'In_{0,12}Ga_{0,88}N non intentionnellement dopé, formant la couche 114. La température est abaissée à environ 730°C pour faire croître 500 nm d'In_{0,18}Ga_{0,82}N dopé par du magnésium, formant la couche 104. La deuxième électrode métallique 103 est ensuite réalisée sous la forme d'une couche de Ni/Au sur la couche dopée p 104, et la première électrode métallique 101 est enfin réalisée sous la forme d'une couche de Ti/Au sur la couche dopée n 102 (après désolidarisation de la couche dopée n 102 avec la première couche de GaN d'épaisseur égale à environ 2 µm).

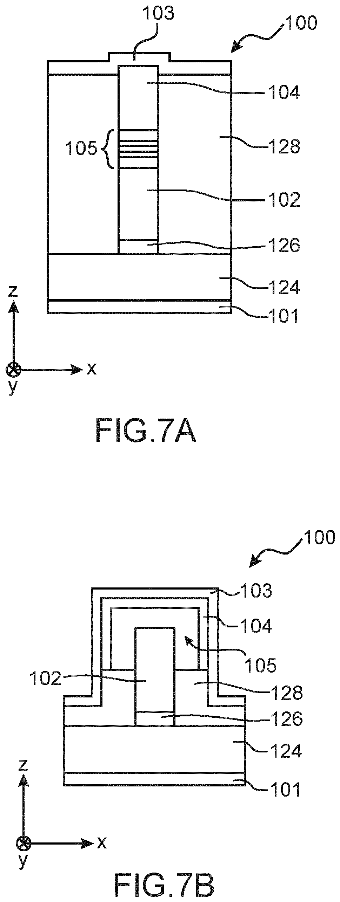

En variante, la LED 100 peut être réalisée sous la forme de nanofils. La figure 7A représente une telle LED 100 réalisée sous la forme de nanofils axiaux, ces nanofils comportant un empilement formé de la première électrode 101, d'un substrat 124 de semi-conducteur (par exemple du gallium) de type n, d'une couche de nucléation 126 permettant la croissance des nanofils, de la couche dopée n 102, de la zone active 105, de la couche dopée p 104, et de la deuxième électrode 103. Un matériau isolant 128 peut entourer au moins une partie de ces nanofils qui s'étendent parallèlement à l'axe Z.

La figure 7B représente une LED 100 réalisée sous la forme de nanofils radiaux, ces nanofils comportant un empilement formé de la première électrode 101, du substrat 124 de semi-conducteur, de la couche de nucléation 126 et de la couche dopée n 102. Des portions isolantes 128 entourent en partie la couche dopée n 102 et la couche de nucléation 126. La zone active 105 (formée au moins des couches 106, 108, 110, 112 et 114) est réalisée telle qu'elle entoure au moins une partie de la couche dopée n 102. La couche dopée p 104 est réalisée telle qu'elle entoure la zone active 105. Enfin, la deuxième électrode 103 est réalisée en recouvrant la couche dopée p 104.

En variante des deux exemples de réalisation décrits sur les figures 7A et 7B, la structure de ces nanofils peut être inversée, avec dans ce cas un substrat 124 de semi-conducteur, par exemple de nitrure de gallium, de type p sur lequel est réalisée la couche dopée p 104, puis les autres éléments de la LED 100 dans l'ordre inverse de celui décrit sur les figures 7A et 7B.

On décrit ci-dessous un exemple de réalisation de la diode 100 sous la forme de nanofils radiaux.

Des nanofils de GaN dopés par du silicium avec une concentration de donneurs égale à environ 3.10¹⁸ donneurs/cm³ sont réalisés par croissance sur un substrat saphir, par exemple par MOCVD à une température d'environ 1050°C, formant également une couche de GaN dopé silicium entre les nanofils, l'ensemble correspondant à la première couche dopée n 102. La température est ensuite abaissée à environ 830 °C pour faire croître une coquille d'environ 50 nm d'épaisseur d'In_{0,05}Ga_{0,95}N non intentionnellement dopé, formant la couche 112. La température est ensuite abaissée à environ 600°C pour faire croître une coquille d'épaisseur égale à environ 3 monocouches d'InN non intentionnellement dopé, formant la première couche d'InN 106. La température est remontée à environ 720°C pour faire croître une coquille d'épaisseur égale à environ 1 nm d'In_{0,2}Ga_{0,8}N non intentionnellement dopé, formant la couche de séparation 110. La température est abaissée de nouveau à environ 600°C pour faire croître une coquille d'épaisseur égale à environ 2 monocouches d'InN non intentionnellement dopé, formant la deuxième couche d'InN 108. La température est remontée à environ 750°C pour faire croître une coquille d'épaisseur égale à environ 10 nm d'In_{0,12}Ga_{0,88}N non intentionnellement dopé, formant la couche 114. La zone active 105 forme ici un empilement de coquilles les unes sur les autres. La température est abaissée à environ 720°C pour faire croître une coquille d'épaisseur égale à environ 500 nm d'In_{0,18}Ga_{0,82}N dopé par du magnésium, formant la couche dopée p 104. La deuxième électrode métallique 103 est ensuite réalisée sous la forme d'une couche de Ni/Au sur la coquille d'In_{0,18}Ga_{0,82}N dopé Mg, et la première électrode métallique 101 est ensuite réalisée sous la forme d'une couche de Ti/Au sur la couche de GaN dopé Si se trouvant entre les nanofils de GaN (couche dopée n de Si 102 précédemment décrite). Avant de déposer l'électrode métallique 101, l'électrode 103 Ni/Au qui est aussi déposée entre les fils est gravée par gravure ionique réactive fluorée pour le nickel et par attaque chimique au KI pour l'or. Selon ce mode de réalisation, on obtient des nanofils dopés n reliés par une couche 2D continue de GaN dopé n. Une électrode contact dans ce cas la coquille externe de type p des nanofils et une électrode contact la couche de GaN de type n entre les nanofils.

Les différentes caractéristiques (épaisseurs, dopage, etc.) précédemment exposées pour la LED 100 de type planaire peuvent être similaires pour la LED 100 réalisée sous la forme de nanofils. Les températures indiquées ci-dessus pour la réalisation de la LED 100 sous forme planaire ou de nanofils varient selon le dispositif MOCVD utilisé. De plus, dans le cas d'une structure de nanofils, les températures peuvent varier en fonction des diamètres, longueurs et densité des nanofils. Pour obtenir des interfaces abruptes entre les différentes couches plus ou moins riches en indium, il est possible de réaliser des dépôts préalables d'indium en surface avant la croissance d'InGaN, et/ou de réaliser une évaporation d'indium en surface après la croissance d'InGaN.

## Revendications

1. Diode électroluminescente (100) comportant au moins une couche d'In_{Xn}Ga_{(1-Xn)}N dopé n (102) et une couche d'In_{Xp}Ga_{(1-Xp})N dopé p (104) formant ensemble une jonction p-n de la diode électroluminescente (100), et une zone active (105) disposée entre la couche d'In_{Xn}Ga_{(1-Xn)}N dopé n (102) et la couche d'In_{Xp}Ga_{(1-Xp)}N dopé p (104) et dans laquelle des recombinaisons radiatives sont aptes à se produire; la zone active (105) comprenant au moins :
- une première couche d'InN (106) d'épaisseur e_{InN106} ;
- une deuxième couche d'InN (108) d'épaisseur e_{InN108} ;
- une couche de séparation (110) disposée entre la première couche d'InN (106) et la deuxième couche d'InN (108) et telle que la première couche d'InN (106) soit disposée entre la couche de séparation (110) et la couche d'In_{Xn}Ga_{(1-Xn)}N dopé n (102), la couche de séparation (110) comprenant de l'In_{Xb}Ga_{(1-Xb)}N
- une couche d'In_{X1}Ga_{(1-X1)}N (112) disposée entre la couche d'In_{Xn}Ga_{(1-Xn)}N dopé n (102) et la première couche d'InN (106) ; et
- une couche d'In_{X2}Ga_{(1-X2})N (114) disposée entre la couche d'In_{Xp}Ga_{(1-Xp})N dopé p (104) et la deuxième couche d'InN (108),
dans laquelle les compositions en indium Xn, Xp, Xb, X1 et X2 sont comprises entre 0 et 0,25,
**caractérisée par** la couche de séparation ayant une épaisseur inférieure ou égale à 3 nm et les épaisseurs e_{InN106} et e_{InN108} étant telles que e_{InN106} < e_{InN108}.

2. Diode électroluminescente (100) selon la revendication 1, dans laquelle les épaisseurs e_{InN106} et e_{InN108} sont comprises entre 1 monocouche et 3 monocouches.

3. Diode électroluminescente (100) selon la revendication 2, dans laquelle, lorsque l'une ou chacune de la première couche d'InN (106) et de la deuxième couche d'InN (108) a une épaisseur comprise entre 2 monocouches et 3 monocouches, la composition en indium Xb est supérieure ou égale à 0,15, ou lorsque la composition en indium Xb est inférieure à 0,15, l'épaisseur de ladite une ou de chacune de la première couche d'InN (106) et de la deuxième couche d'InN (108) est inférieure ou égale à 2 monocouches,

4. Diode électroluminescente (100) selon l'une des revendications précédentes, dans laquelle les compositions en indium X1 et X2 sont telles que X1 ≤ X2, ou dans laquelle les compositions en indium Xn, Xp, Xb, X1 et X2 sont telles que Xn < X1 < X2 < Xp, ou telles que Xn = Xp = 0 et/ou X1 = Xb = X2.

5. Diode électroluminescente (100) selon l'une des revendications précédentes, dans laquelle l'épaisseur de la couche d'In_{Xn}Ga_{(1-Xn)}N dopé n (102) et/ou l'épaisseur de la couche ('In_{Xp}Ga_{(1-Xp)}N dopé p (104) est comprise entre 20 nm et 10 µm, et/ou l'épaisseur de la couche d'In_{X1}Ga_{(1-X1)}N (112) et/ou J'épaisseur de la couche d'In_{X2}Ga_{(1-X2)}N (114) est comprise entre 1 nm et 200 nm.

6. Diode électroluminescente (100) selon l'une des revendications précédentes, comportant en outre une première électrode métallique (101) disposée contre la couche d'In_{Xn}Ga_{(1-Xn)}N dopé n (102) et une deuxième électrode métallique (103) disposée contre la couche l'In_{Xp}Ga_{(1-Xp)}N dopé p (104).

7. Diode électroluminescente (100) selon l'une des revendications précédentes, dans laquelle la zone active (105) comporte un nombre de couches d'InN supérieur à 2, chacune des couches d'InN étant séparée de la ou de chacune des couches d'InN adjacentes par une couche de séparation comprenant de l'InGaN ou du GaN et d'épaisseur inférieure ou égale à 3 nm.

8. Diode électroluminescente (100) selon l'une des revendications précédentes, comportant plusieurs zones actives (105) disposées entre la couche d'In_{Xn}Ga_{(1-Xn)}N dopé n (102) et la couche d'In_{Xp}Ga_{(1-Xp)}N dopé p (104) et dans lesquelles des recombinaisons radiatives sont aptes à se produire.

9. Diode électroluminescente (100) selon l'une des revendications précédentes, comportant en outre, entre la couche d'In_{Xn}Ga_{(1-Xn)}N dopé n (102) et la zone active (105), une couche tampon d'InGaN dopé n, l'InGaN dopé n de la couche tampon comportant une énergie de bande interdite inférieure ou égale à 97 % de l'énergie de bande interdite de l'In_{Xp}Ga_{(1-Xp)}N dopé p.

10. Procédé de réalisation d'une diode électroluminescente (100) selon l'une des revendications 1 à 9, dans lequel les couches de la diode électroluminescente (100) sont des couches planaires réalisées par croissance les unes au-dessus des autres, ou dans lequel les couches de la diode électroluminescente (100) sont réalisées par croissance sous la forme de nanofils radiaux ou axiaux.

## Patentansprüche

1. Leuchtdiode (100), umfassend wenigstens eine n-dotierte Schicht aus In_{Xn}Ga_{(1-Xn)}N (102) und eine p-dotierte Schicht aus In_{Xp}Ga_{(1-Xp)}N (104), die zusammen einen pn-Übergang der Leuchtdiode (100) bilden, sowie eine aktive Zone (105), die zwischen der n-dotierten Schicht aus In_{Xn}Ga_{(1-Xn)}N (102) und der p-dotierten Schicht aus In_{Xp}Ga_{(1-Xp)}N (104) angeordnet ist und in der sich strahlende Rekombinationen ereignen können, wobei die aktive Zone (105) wenigstens umfasst:
- eine erste Schicht aus InN (106) mit einer Dicke e_{InN106};
- eine zweite Schicht aus InN (108) mit einer Dicke e_{InN108};
- eine Separationsschicht (110), die zwischen der ersten Schicht aus InN (106) und der zweiten Schicht aus InN (108) angeordnet ist derart, dass die erste Schicht aus InN (106) zwischen der Separationsschicht (110) und der n-dotierten Schicht aus In_{Xn}Ga_{(1-Xn)}N (102) angeordnet ist, wobei die Separationsschicht (110) In_{Xb}Ga_{(1-Xb)}N umfasst;
- eine Schicht aus In_{X1}Ga_{(1-X1)}N (112), die zwischen der n-dotierten Schicht aus In_{Xn}Ga_{(1-Xn)}N (102) und der ersten Schicht aus InN (106) angeordnet ist; und
- eine Schicht aus In_{X2}Ga_{(1-X2)}N (114), die zwischen der p-dotierten Schicht aus In_{Xp}Ga_{(1-Xp)}N (104) und der zweiten Schicht aus InN (108) angeordnet ist,
wobei die Indium-Zusammensetzungen Xn, Xp, Xb, X1 und X2 zsichen 0 und 0,25 enthalten sind,
**dadurch gekennzeichnet, dass** die Separationsschicht eine Dicke kleiner oder gleich 3 nm hat, und dass die Dicken e_{InN106} und e_{InN108} derart sind, dass e_{InN106} < e_{InN108}.

2. Leuchtdiode (100) nach Anspruch 1, wobei die Dicken e_{InN106} und e_{InN108} zwischen 1 Monoschicht und 3 Monoschichten enthalten sind.

3. Leuchtdiode (100) nach Anspruch 2, wobei dann, wenn eine oder jede von der ersten Schicht aus InN (106) und der zweiten Schicht aus InN (108) eine Dicke hat, die zwischen 2 Monoschichten und 3 Monoschichten enthalten ist, die Indiumzusammensetzung Xb größer oder gleich 0,15 ist, oder wenn die Indiumzusammensetzung Xb kleiner als 0,15 ist, die Dicke der einen oder jeder von der ersten Schicht aus InN (106) und der zweiten Schicht aus InN (108) kleiner oder gleich 2 Monoschichten ist.

4. Leuchtdiode (100) nach einem der vorhergehenden Ansprüche, wobei die Indiumzusammensetzungen X1 und X2 derart sind, dass X1 ≤ X2, oder wobei die Indiumzusammensetzungen Xn, Xp, Xb, X1 und X2 derart sind, dass Xn < X1 < X2 < Xp, oder derart, dass Xn = Xp = 0 und/oder X1 = Xb = X2.

5. Leuchtdiode (100) nach einem der vorhergehenden Ansprüche, wobei die Dicke der n-dotierten Schicht aus In_{Xn}Ga_{(1-Xn)}N (102) und/oder die Dicke der p-dotierten Schicht aus In_{Xp}Ga_{(1-Xp)}N (104) zwischen 20 nm und 10µm enthalten ist, und/oder die Dicke der Schicht aus In_{X1}Ga_{(1-X1)}N (112) und/oder die Dicke der Schicht aus In_{X2}Ga_{(1-X2)}N (114) zwischen 1 nm und 200 nm enthalten ist.

6. Leuchtdiode (100) nach einem der vorhergehenden Ansprüche, ferner umfassend eine erste metallische Elektrode (101), die an der n-dotierten Schicht aus In_{Xn}Ga_{(1-Xn)}N (102) angeordnet ist, und eine zweite metallische Elektrode (103), die an der p-dotierten Schicht aus In_{Xp}Ga_{(1-Xp)}N (104) angeordnet ist.

7. Leuchtdiode (100) nach einem der vorhergehenden Ansprüche, wobei die aktive Zone (105) eine Zahl von Schichten aus InN größer als 2 umfasst, wobei jede der Schichten aus InN von der oder jeder der angrenzenden Schichten aus InN durch eine Separationsschicht separiert ist, die InGaN oder GaN umfasst und eine Dicke kleiner oder gleich 3 nm hat.

8. Leuchtdiode (100) nach einem der vorhergehenden Ansprüche, umfassend mehrere aktive Zonen (105), die zwischen der n-dotierten Schicht aus In_{Xn}Ga_{(1-Xn)}N (102) und der p-dotierten Schicht aus In_{Xp}Ga_{(1-Xp)}N (104) angeordnet sind, und in denen sich strahlende Rekombinationen ereignen können.

9. Leuchtdiode (100) nach einem der vorhergehenden Ansprüche, ferner umfassend zwischen der n-dotierten Schicht aus In_{Xn}Ga_{(1-Xn)}N (102) und der aktiven Schicht (105) eine Pufferschicht aus n-dotiertem InGaN, wobei das n-dotierte InGaN der Pufferschicht eine Energie des verbotenen Bands kleiner oder gleich 97 % der Energie des verbotenen Bands des p-dotierten In_{Xp}Ga_{(1-Xp)}N umfasst.

10. Verfahren zur Herstellung einer Leuchtdiode (100) nach einem der Ansprüche 1 bis 9, wobei die Schichten der Leuchtdiode (100) planare Schichten sind, die durch Aufwachsen der einen auf den anderen realisiert sind, oder wobei die Schichten der Leuchtdiode (100) durch Aufwachsen in Form von radialen oder axialen Nanodrähten realisiert sind.

## Claims

1. Light emitting diode (100) including at least one n-doped In_{Xn}Ga_{(1-Xn)}N layer (102) and a p-doped In_{Xp}Ga_{(1-Xp)}N layer (104) forming together a p-n junction of the light emitting diode (100), and an active area (105) arranged between the n-doped In_{Xn}Ga_{(1-Xn)}N layer (102) and the p-doped In_{Xp}Ga_{(1-Xp)}N layer (104) and wherein radiative recombinations are able to occur, the active area (105) including at least:
- a first InN layer (106) with a thickness e_{InN106};
- a second InN layer (108) with a thickness e_{InN108};
- a separating layer (110) arranged between the first InN layer (106) and the second InN layer (108) and such that the first InN layer (106) is arranged between the separating layer (110) and the n-doped In_{Xn}Ga_{(1-Xn)}N layer (102), the separating layer (110) comprising In_{Xb}Ga_{(1-Xb)}N;
- an In_{X1}Ga_{(1-X1)}N layer (112) arranged between the n-doped In_{Xn}Ga_{(1-Xn)}N layer (102) and the first InN layer (106); and
- an In_{X2}Ga_{(1-X2)}N layer (114) arranged between the p-doped In_{Xp}Ga_{(1-Xp)}N layer (104) and the second InN layer (108),
wherein the indium compositions Xn, Xp, Xb, X1 and X2 are between 0 and 0.25, **characterized by** the separating layer having a thickness lower than or equal to 3 nm and the thicknesses e_{InN106} and e_{InN108} being such that e_{InN106} < e_{InN108}.

2. The light emitting diode (100) according to claim 1, wherein the thicknesses e_{InN106} and e_{InN108} are between 1 single layer and 3 single layers.

3. The light emitting diode (100) according to claim 2, wherein, when one or each of the first InN layer (106) and the second InN layer (108) has a thickness between 2 single layers and 3 single layers, the indium composition Xb is higher than or equal to 0.15, or when the indium composition Xb is lower than 0.15, the thickness of said one or each of the first InN layer (106) and the second InN layer (108) is lower than or equal to 2 single layers.

4. The light emitting diode (100) according to one of the preceding claims, wherein the indium compositions X1 and X2 are such that X1 ≤ X2, or wherein the indium compositions Xn, Xp, Xb, X1 and X2 are such that Xn < X1 < X2 < Xp, or such that Xn = Xp = 0 and/or X1 = Xb = X2.

5. The light emitting diode (100) according to one of the preceding claims, wherein the thickness of the n-doped In_{Xn}Ga_{(1-Xn)}N layer (102) and/or the thickness of the p-doped In_{Xp}Ga_{(1-Xp)}N layer (104) is between 20nm and 10µm, and/or the thickness of the In_{X1}Ga_{(1-X1)}N layer (112) and/or the thickness of the In_{X2}Ga_{(1-X2)}N layer (114) is between 1nm and 200nm.

6. The light emitting diode (100) according to one of the preceding claims, further including a first metal electrode (101) arranged against the n-doped In_{Xn}Ga_{(1-Xn)}N layer (102) and a second metal electrode (103) arranged against the p-doped In_{Xp}Ga_{(1-Xp)}N layer (104).

7. The light emitting diode (100) according to one of the preceding claims, wherein the active area (105) includes a number of InN layers higher than 2, each of the InN layers being separated from the or each of the adjacent InN layers by a separating layer comprising InGaN or GaN and with a thickness lower than or equal to 3nm.

8. The light emitting diode (100) according to one of the preceding claims, including several active areas (105) arranged between the n-doped In_{Xn}Ga_{(1-Xn)}N layer (102) and the p-doped In_{Xp}Ga_{(1-Xp)}N layer (104) and wherein radiative recombinations are able to occur.

9. The light emitting diode (100) according to one of the preceding claims, further including, between the n-doped In_{Xn}Ga_{(1-Xn)}N layer (102) and the active area (105), an n-doped InGaN buffer layer, the n-doped InGaN of the buffer layer including a band gap energy lower than or equal to 97% of the band gap energy of the p-doped In_{Xp}Ga_{(1-Xp)}N.

10. A method for making a light emitting diode (100) according to one of claims 1 to 9, wherein the layers of the light emitting diode (100) are planar layers made by growing over each other, or wherein the layers of the light emitting diode (100) are made by growing as radial or axial nanowires.
